(19) Europäisches Patentamt
European Patent Office
Office européen des brevets

(11) **EP 0 624 802 B1**

(12) **EUROPÄISCHE PATENTSCHRIFT**

(45) Veröffentlichungstag und Bekanntmachung des Hinweises auf die Patenterteilung:
**25.07.2001 Patentblatt 2001/30**

(51) Int Cl.⁷: $G01R\ 19/22$, $G06G\ 7/20$

(21) Anmeldenummer: **94106875.1**

(22) Anmeldetag: **03.05.1994**

(54) **Schaltungsanordnung zum Gleichrichten von Wechselspannungssignalen**

Alternating voltage signals rectifying circuit

Circuit pour le redressement de signaux de tension alternative

(84) Benannte Vertragsstaaten:
**CH DE FR GB IT LI**

(30) Priorität: **13.05.1993 DE 4316027**

(43) Veröffentlichungstag der Anmeldung:
**17.11.1994 Patentblatt 1994/46**

(73) Patentinhaber: **ATMEL Germany GmbH**
**74072 Heilbronn (DE)**

(72) Erfinder: **Böhme, Rolf, Dr.**
**D-74177 Bad Friedrichshall (DE)**

(74) Vertreter: **Kolb, Georg et al**
**DaimlerChrysler AG,**
**Theresienstrasse 2**
**74072 Heilbronn (DE)**

(56) Entgegenhaltungen:
**EP-A- 0 503 628**            **DE-A- 2 558 554**
**GB-A- 2 260 870**

- **IEICE TRANSACTIONS ON ELECTRONICS, Bd. 76-C, Nr. 5, Mai 1993 TOKYO JP, Seiten 714-737, K.KIMURA 'A Unified Analysis of Four-Quadrant Analog Multipliers Consisting of Emitter and Source-Coupled Transistors Operable on Low Supply Voltage'**
- **IEEE JOURNAL OF SOLID-STATE CIRCUITS, Bd. 29, Nr. 1, Januar 1994 NEW YORK US, Seiten 46-55, K.KIMURA 'A Bipolar Four-Quadrant Analog Quarter-Square Multiplier Consisting of Unbalanced Emitter-Coupled Pairs and Expansions of Its Input Ranges'**
- **PATENT ABSTRACTS OF JAPAN Bd. 12, Nr. 233 (P-724) 05 Juli 1988 & JP 63 024 377 A (NEC) 01 Februar 1988**

**Beschreibung**

Die Erfindung betrifft ein Verfahren zur Gleichrichtung eines von einer Signalquelle erzeugten Wechselspannungssignals unter Verwendung einer Schaltungsanordnung gemäß dem Oberbegriff der Patentansprüche 1 bis. 4.

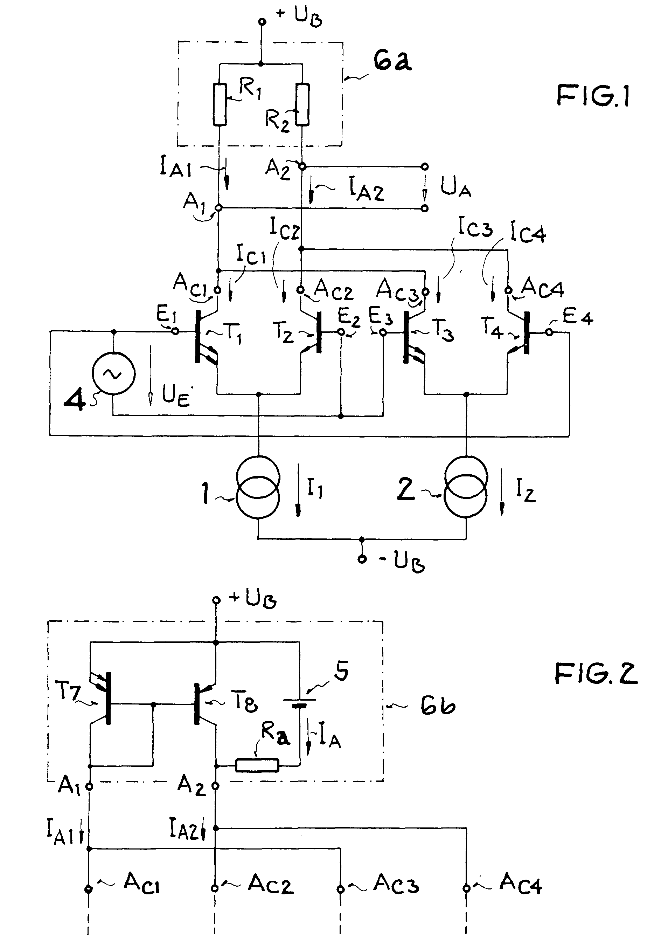

Eine solche Schaltungsanordnung mit den oberbegrifflichen Merkmalen a bis e der Ansprüche 1 und 2 ist aus IEICE TRANSACTIONS ON ELECTRONICS, Bd. 76-C, Nr. 5, Mai 1993 Tokyo, Japan, Seiten 714-737, K. Kimura: 'A Unified Analysis of Four-Quadrant Analog Multipliers Consisting of Emitter and Source-Coupled Transistors Operable on Low Supply Voltage', insbesondere Fig. 2a bekannt. Dort wird diese Schaltungsanordnung als Quadrierschaltung verwendet, indem den verbundenen Basis-Elektroden ein Wechselspannungssignal zugeführt wird.

Die Figur 4 dieser Druckschrift zeigt eine Schaltungsanordnung mit den oberbegrifflichen Merkmalen a bis e der Ansprüche 3 und 4. Zu dieser Schaltungsanordnung wird ausgeführt, daß diese schon zur Gleichrichtung verwendet wurde.

Ferner ist aus der GB-A-2 260 870 eine Schaltungsanordnung mit den Merkmalen a, b, c und d der Ansprüche 1 und 2 bekannt und wird als Quadrierschaltung eingesetzt.

Diese bekannten Schaltungsanordnungen besitzen die Eigenschaft, daß sich die Differenz der beiden Ausgangsströme proportional zu der Differenz der beiden an jeweils eine der beiden Eingänge angelegten Eingangsspannungen verhalten.

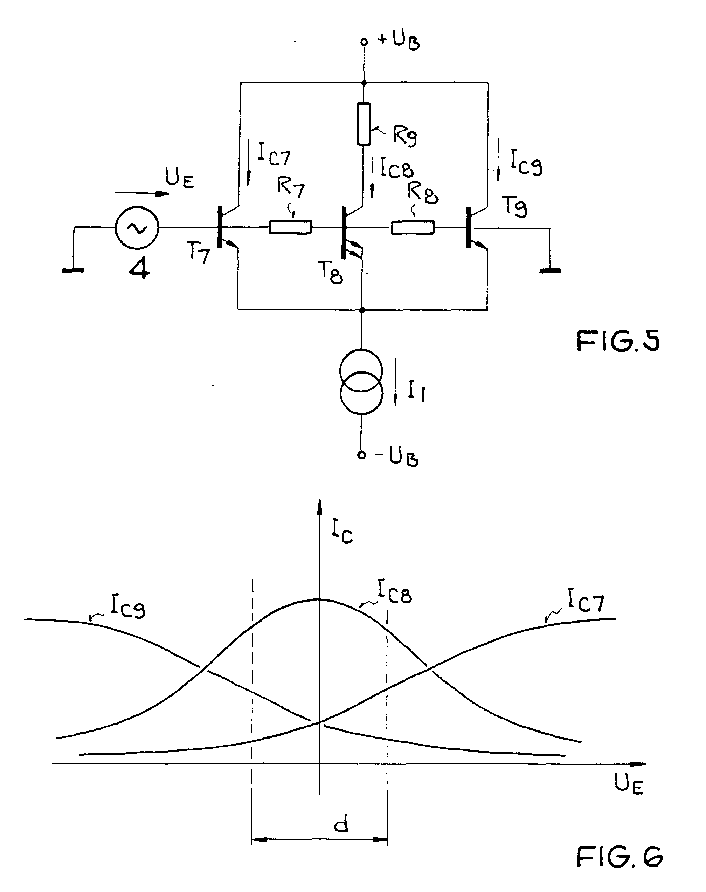

Des weiteren ist aus "Analog IC Design: the current-mode approach", von C. Tamazou, F. J. Lidgey und D. G. Haigh, herausgegeben von Peter Peregrinus Ltd. London 1990, Fig. 2.10 eine weitere Schaltung zum Gleichrichten von Wechselspannungssignalen bekannt, dessen gleichgerichtetes Signal eine angenähert quadratische Charakteristik aufweist. Diese Schaltung ist in Figur 5 dargestellt und ist mit drei npn-Transistoren $T_7$, $T_8$ und $T_9$ aufgebaut. Die Emitterfläche es mittleren Transistors $T_8$ ist n-mal größer als diejenigen Flächen der beiden anderen Transistoren $T_7$ und $T_9$. Die Emitter-Elektroden dieser drei Transistoren werden von einer einzigen Konstantstromquelle gespeist, die einen Strom $I_1$ liefert. Zwischen den Basen des Transistors $T_7$ und $T_8$ bzw. $T_8$ und $T_9$ ist jeweils ein Widerstand $R_7$ bzw. $R_8$ mit identischen Widerstandswerten geschaltet. Somit wird ein von einer Signalquelle 4 geliefertes Wechselspannungssignal $U_e$ der Basis-Elektrode des Transistors $T_7$ direkt zugeführt, dem Transistor $T_8$ jedoch nur zur Hälfte. Schließlich sind die Kollektor-Elektroden er Transistoren $T_7$ und $T_9$ direkt mit einer Betriebsspannungsquelle $U_B$ verbunden, während diejenige des mittleren Transistors $T_8$ über einen Arbeitswiderstand $R_9$ an diese Betriebsspannungsquelle angeschlossen ist.

Im folgenden soll die Funktion dieser Schaltung anhand des $U_e$-$I_c$-Diagramms nach Figur 6 erläutert werden. Mit einem Flächenverhältnis n zwischen den Transistoren $T_8$ und $T_7$ bzw. $T_8$ und $T_9$ fließt im Ruhezustand ein Kollektorstrom $I_{C8}$ des Transistors $T_8$ von $I_1 \cdot n/(n + 2)$ durch den Arbeitswiderstand $R_9$. Dies ist in dem Diagramm nach Figur 6 der Schnittpunkt der Kurve $I_{C8}$ mit der Ordinatenachse.

Bei einer Eingangsspannung $U_e$ = 0 übernimmt dagegen der Transistor $T_7$ oder $T_9$ einen wachsenden Teil des Stromes wie dies die Kurven $I_{C7}$ bzw. $I_{C8}$ gemäß Figur 6 zeigen. Gleichzeitig nimmt jedoch der Strom $I_{C8}$ ab, dessen Verlauf im Bereich des Wertes Null der Eingangsspannung $U_e$ (siehe Bereich d gemäß Figur 6) durch eine Parabel zweiten Grades angenähert wird. Somit steigt die Spannung am Kollektor des Transistors $T_8$ gegenüber dem Ruhewert an. Dies entspricht einer Gleichrichtung des Wechselspannungssignals $U_e$ mit quadratischer Charakteristik.

Bei dieser bekannten Schaltung nach Figur 5 ist jedoch der Leistungsverbrauch in den beiden Widerständen $R_7$ und $R_8$ nachteilig. Eine große Eingangsspannung $U_e$ erforderlich.

Die Aufgabe der Erfindung besteht darin, ein verfahren der eingangs genannten Art anzugeben, die mit kleiner Versorgungsspannung sicher betrieben werden kann und außerdem nur einen geringen Strombedarf aufweist.

Diese Aufgabe wird unter Verwendung einer bekannten Schaltungsanordnung durch die kennzeichnenden Merkmale der Patentansprüche 1 bis 4 gelöst.

Die Verwendung der bekannten Schaltungsanordnungen weisen gegenüber derjenigen nach Figur 5 den Vorteil auf, daß sie bei sonst gleichen Kennlinien nur die halbe Eingangsspannung $U_e$ für den sicheren Betrieb benötigt, da ein eingangsseitiger Spannungsteiler entfällt. Auch arbeiten diese bekannten Schaltungen wesentlich schneller als übliche, mit Gleichrichterdioden aufgebaute Brückenschaltungen.

Ein weiterer Vorteil ist darin zu sehen, daß die Ausgangskennlinie der bekannten Schaltungsanordnungen im Bereich des Nullpunktes näherungsweise eine leistungsproportionale Größe vorliegt.

Durch die Verwendung einer Ausgangsschaltung mit zwei ohmschen Arbeitswiderständen, deren Leitwerte im Verhältnis der Unsymmetrie der Differenzverstärkerstufen ausgebildet sind, nimmt der resultierende Ausgangsstrom im Ruhezustand der Schaltungsanordnung den wert Null an.

Werden dagegen die beiden Ausgänge über eine Stromspiegelschaltung verbunden, deren Spiegelfaktor entsprechend der Unsymmetrie der Differenzverstärkerstufen eingestellt wird, so nimmt auch hier der Ruhestrom den Wert Null an. Gleichzeitig erhöht man in vorteilhafter Weise eine Addition der quadratischen Anteile des Ausgangsstromes.

Bei einer vorteilhaften Weiterbildung der Erfindung gemäß den Ansprüchen 3 und 4 werden die Offset-Spannungen an Abgriffen von Arbeitswiderständen einer vorgeschalteten Differenzverstärkerstufe erzeugt.

Solche symmetrisch aufgebaute Differenzverstärkerstufen bieten den Vorteil, daß hierfür untereinander gleiche Transistoren verwendet werden können.

Im folgenden soll die Erfindung anhand von Ausführungsbeispielen im Zusammenhang mit den Zeichnungen dargestellt und erläutert werden. Es zeigen:

Figur 1      eine Schaltungsanordnung als Ausführungsbeispiel der Erfindung,

Figur 2      eine alternative Ausgangsschaltng zu dem Ausführungsbeispiel gemäß Figur 1,

Figur 3      eine Schaltungsanordnung eines weiteren Ausführungsbeispieles der Erfindung und

Figur 4      Strom-Spannungs-Kennlinien zur Erläuterung der Funktion der Ausführungsbeispiele.

Die Schaltungsanordnung nach Figur 1 zeigt zwei Differenzverstärkerstufen, die mit npn-Transistoren $T_1$ und $T_2$ bzw. $T_3$ und $T_4$ aufgebaut sind. Eine Signalquelle 4 erzeugt als Eingangsspannung ein Wechselspannungssignal $U_e$, das gleichzeitig beiden Differenzverstärkerstufen zugeführt wird. Bei den beiden Differenzverstärkerstufen ist jeweils ein Transistor $T_1$ bzw. $T_3$ mit einer n-mal größeren Emitterfläche als diejenige des jeweiligen Partnertransistors $T_2$ bzw. $T_4$ ausgebildet, was in der Figur mit doppelten Emitterpfeilen dargestellt ist. Die Differenzverstärkerstufen $T_1/T_2$ weist zwei Eingänge $E_1$ und $E_2$ auf, die je mit einem Anschluß der Signalquelle 4 verbunden sind. Die zweite Differenzverstärkerstufe $T_3/T_4$ ist dagegen mit ihren beiden Eingängen $E_3$ und $E_4$ hinsichtlich der Unsymmetrie im Vergleich zu der ersten Differenzverstärkerstufe $T_1/T_2$ nicht gleichsinnig an die Signalquelle 4 angeschlossen. Der Eingang $E_3$ des größeren Transistors $T_3$ ist daher nicht an den gleichen Anschluß der Signalquelle 4 angeschlossen wie der entsprechende größere Transistor $T_1$ der ersten Differenzverstärkerstufe $T_1/T_2$, sondern an den Anschluß, an den der Eingang $E_2$ des kleineren Transistors $T_2$ angeschlossen ist. Entsprechend ist auch der kleinere Transistor $T_4$ der zweiten Differenzverstärkerstufe $T_3/T_4$ mit seinem Eingang $E_4$ an denjenigen Anschluß der Signalquelle 4 angeschlossen, mit dem der Eingang $E_1$ des größeren Transistors $T_1$ der ersten Differenzverstärkerstufe $T_1/T_2$ verbunden ist.

Die Kollektor-Anschlüsse $A_{c1}$ und $A_{c2}$ bzw. $A_{c3}$ und $A_{c4}$ der beiden Differenzverstärkerstufen sind dagegen gleichsinnig hinsichtlich der Unsymmetrie verbunden, d. h., daß der Kollektor-Anschluß $A_{c1}$ des größeren Transistors $T_1$ der ersten Differenzverstärkerstufe $T_1/T_2$ mit demjenigen Kollektor-Anschluß $A_{c3}$ des größeren Transistors $T_3$ der zweiten Differenzverstärkerstufe $T_3/T_4$ unter Bildung eines ersten Ausganges $A_1$ zusammengeführt ist und entsprechend sind die Kollektor-Anschlüsse $A_{c2}$ und $A_{c4}$ der jeweils kleineren Partnertransistoren $T_2$ und $T_4$ zu einem zweiten Ausgang $A_2$ zusammengeschaltet.

An diese beiden Ausgänge $A_1$ und $A_2$ ist eine Ausgangsschaltung 6a mit einem ersten und zweiten ohmschen Arbeitswiderstand $R_1$ und $R_2$ angeschlossen, die einerseits jeweils mit dem ersten bzw. zweiten Ausgang $A_1$ bzw. $A_2$ verbunden sind und andererseits auf dem Potential der positiven Betriebsspannung $U_B$ liegen.

An den beiden Ausgängen $A_1$ und $A_2$ ist eine Ausgangsspannung $U_A$ abgreifbar, die die Differenz der beiden zusammengeschalteten Kollektor-Potentiale darstellt.

Schließlich wird jede Differenzverstärkerstufe $T_1/T_2$ bzw. $T_3/T_4$ von einer Konstantstromquelle 1 bzw. 2 versorgt, die ihrerseits auf dem Potential der negativen Betriebsspannung $U_B$ liegen. Somit fließt in die erste Differenzverstärkerstufe $T_1/T_2$ ein Konstantstrom $I_1$ und in die zweite die zweite Differenzverstärkerstufe $T_3/T_4$ ein Konstantstrom $I_2$.

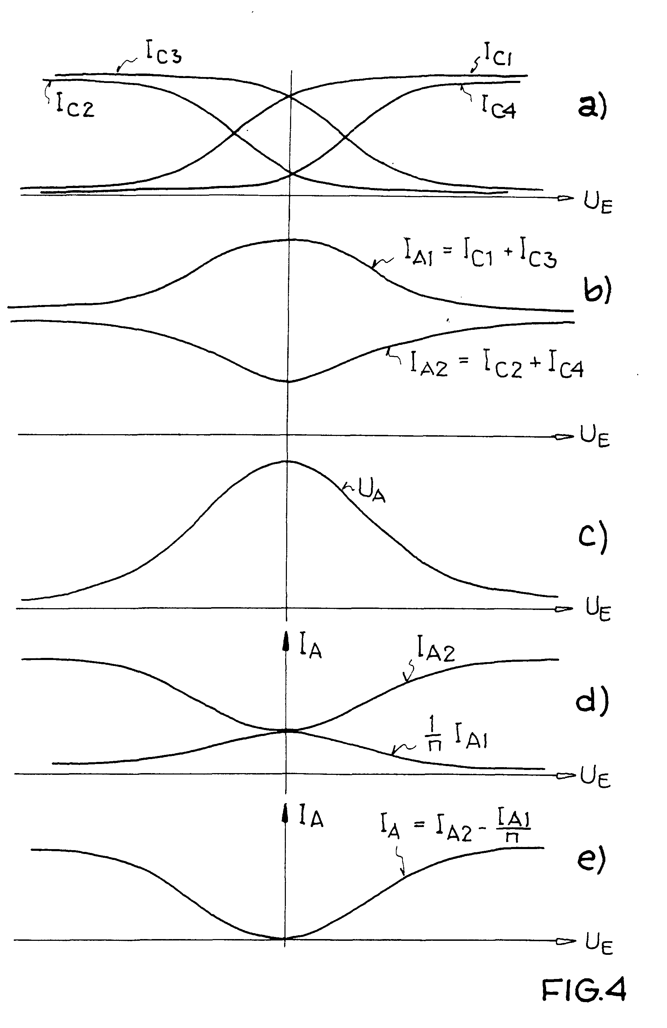

Im folgenden soll die Wirkungsweise der erfindungsgemäßen Schaltung nach Figur 1 im Zusammenhang mit den $U_e$-$I_C$-Kennlinien gemäß den Figuren 4a bis 4c erläutert werden. Im Ruhezustand, also bei einem Wechselspannungssignal von $U_e = 0$ verteilt sich der einfließende Strom $I_1$ bzw. $I_2$ entsprechend dem Flächenverhältnis n. Dem Ausgang $A_1$ fließt somit ein Strom $I_{C1}$ aus der ersten Differenzverstärkerstufe $T_1/T_2$ und ein Strom $I_{C3}$ aus der zweiten Differenzverstärkerstufe $T_3/T_4$ mit dem Wert

$$I_{C1} + I_{C3} = \frac{n}{(n + 1)} (I_1 + I_2)$$

zu. Dem zweiten Ausgang $A_2$ fließt dagegen die Summe der beiden Kollektorströme $I_{C2}$ und $I_{C4}$ der entsprechenden kleineren Partnertransistoren $T_2$ und $T_4$ mit dem Wert

$$I_{C2} + I_{C4} = \frac{1}{(n + 1)} (I_1 + I_2)$$

zu. Die entsprechenden Werte bei $U_e = 0$ sind auch in den Figuren 4a und 4b dargestellt.

Wird das Verhältnis der Leitwerte der beiden Widerstände $R_1$ und $R_2$ entsprechend dem Flächenverhältnis n der Transistoren der beiden Differenzverstärkerstufen gewählt, stellt sich am Ausgang $U_A$ ein Ruhestrom mit dem Wert Null ein.

Bei einer positiven Aussteuerung erhöht sich in der ersten Differenzverstärkerstufe $T_1/T_2$ weiterhin der Kollektorstrom $I_{C1}$ und der Kollektorstrom $I_{C2}$ des Partnertransistors $T_2$ verringert sich weiter, wogegen sich der Kollektorstrom $I_{C3}$ des größeren Transistors $T_3$ der zweiten Differenzverstärkerstufe $T_3/T_4$ aufgrund der ungleichsinnigen Anschaltung an die Signalquelle 4 verringert und gleichzeitig sich der Kollektorstrom $I_{C4}$ des

Partnertransistors $T_4$ erhöht. Die entsprechenden Kennlinien sind in der Figur 4a dargestellt. Der Verlauf der den beiden Ausgängen $A_1$ und $A_2$ jeweils zugeführte Summenstrom $I_{A1}$ und $I_{A2}$ sind der Figur 4b zu entnehmen. Die beiden Ausgänge $A_1$ und $A_2$ liefern also jeweils ein gleichgerichtetes Wechselspannungssignal, das im Bereich von $U_e = 0$ näherungsweise eine quadratische Charakteristik aufweist. Die Ausgangsspannung $U_A$ stellt die Differenz der an den beiden Ausgängen $A_1$ und $A_2$ vorhandenen Spannungspotentiale dar und ist in Figur 4c dargestellt, wobei in der Umgebung von $U_e = 0$ der näherungsweise parabelförmige Verlauf erhalten bleibt.

Die Schaltungsanordnung nach Figur 1 weist die Besonderheit auf, daß bei sehr großer Aussteuerung die Ausgangsströme $I_{A1}$ und $I_{A2}$ unabhängig von der Polarität der Eingangsspannung $U_e$ sich in ihrem Wert aneinander angleichen, wie dies auch dem Diagramm nach Figur 4b entnehmbar ist.

Die Schaltungsanordnung nach Figur 2 zeigt eine alternative Ausgangsschaltung 6b bei ansonsten gleicher Beschaltung wie nach Figur 1. Die Ausgangsschaltung 6b enthält einen Stromspiegel mit zwei pnp-Transistoren $T_7$ und $T_8$ sowie die Ersatzschaltung einer Folgestufe aus einer Gleichspannungsquelle 5 und einem Ausgangswiderstand $R_a$. Der als Diode geschaltete Transistor $T_7$ ist mit dem ersten Ausgang $A_1$ und der zugehörige Stromquellentransistor $T_8$ ist mit dem zweiten Ausgang $A_2$ verbunden. Ferner überbrückt die Reihenschaltung aus der Gleichspannungsquelle 5 und dem Ausgangswiderstand $R_a$ die Emitter-Kollektorstrecke des Stromquellentransistors $T_8$ der Stromspiegelschaltung. Schließlich sind die Emitter-Elektroden der die Stromspiegelschaltung bildenden Transistoren $T_7$ und $T_8$ auf das positive Potential der Betriebsspannungsquelle $U_B$ gelegt. Bei dieser Stromspiegelschaltung entspricht der Spiegelwert dem Flächenverhältnis n der Differenzverstärkerstufe $T_1/T_2$ bzw. $T_3/T_4$, wodurch der Ruhestrom auf den Wert Null kompensiert wird, d. h. bei einer Eingangsspannung $U_e = 0$ fließt ein Ausgangsstrom $I_A$ durch den Ausgangswiderstand $R_a$ mit dem Wert Null. Die entsprechenden Stromverläufe sind in den Figuren 4d und 4e dargestellt. Auch der Ausgangsstrom $I_A$ gemäß der Figur 4e weist in der Umgebung der Eingangsspannung des Wertes $U_e = 0$ näherungsweise einen parabelförmigen Verlauf auf, wobei die quadratischen Anteile der beiden Ausgangsströme $I_{A1}$ und $I_{A2}$ addiert sind.

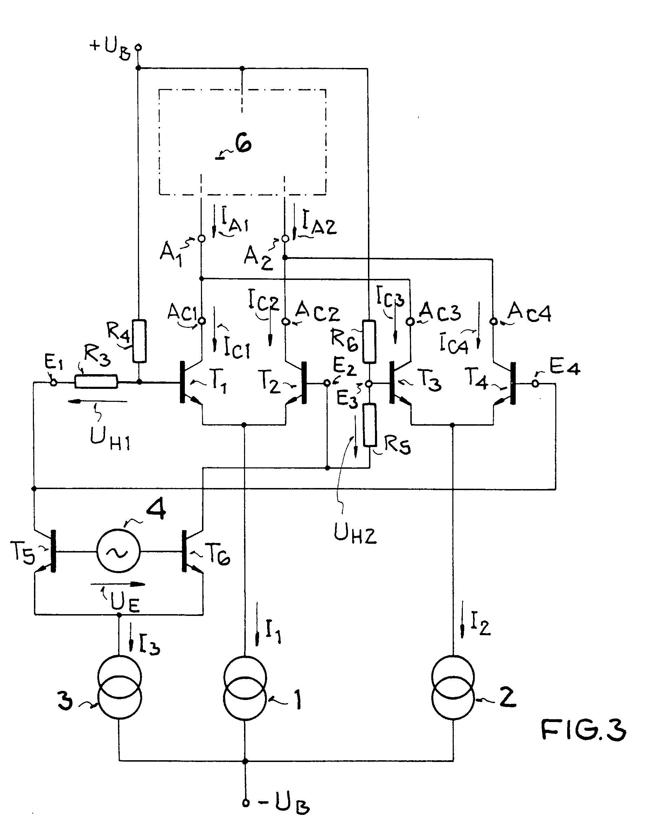

Die Figur 3 zeigt ein Ausführungsbeispiel der Erfindung, bei der die beiden Differenzverstärkerstufen $T_1/T_2$ und $T_3/T_4$ jeweils mit identischen Transistoren aufgebaut sind. Die Unsymmetrie bei diesen beiden Differenzverstärkerstufen wird mittels einer Hilfsspannung $U_{H1}$ bzw. $U_{H2}$ erreicht, die jeweils mittels eines Spannungsteilers $R_3/R_4$ bzw. $R_5/R_6$ erzeugt werden. Diese beiden Spannungsteiler stellen jeweils Arbeitswiderstände von einer dritten Differenzverstärkerstufe dar, die aus npn-Transistoren $T_5$ und $T_6$ aufgebaut ist. Dabei

ist die Signalquelle 4 direkt an die beiden Basen der Transistoren $T_5$ und $T_6$ geschaltet, wobei deren Emitter-Elektroden von einer dritten Konstantstromquelle 3 gespeist wird. Als Ausgangsschaltung. 6 kann entweder die Ausgangsschaltung 6a nach Figur 1 oder die Ausgangsschaltung 6b nach Figur 2 eingesetzt werden.

Die Ausführungsbeispiele der Erfindung nach den Figuren 1 bis 3 können auch mit solchen Bipolartransistoren aufgebaut werden, die den entgegengesetzten Leitfähigkeitstyp aufweisen.

Statt der Verwendung von Differenzverstärkerstufen in ihrem einfachen Aufbau gemäß den in den Figuren dargestellten Ausführungsbeispielen können auch komplex aufgebaute Differenzverstärkerstufen, wie beispielsweise Darlington-Differenzverstärkerstufen, Komplementär-Differenzverstärkerstufen oder Darlington-Komplementär-Differenzverstärkerstufen eingesetzt werden.

## Patentansprüche

1.  Verfahren zur Gleichrichtung eines von einer Signalquelle (4) erzeugten Wechselspannungssignals ($U_e$) unter Verwendung einer Schaltungsanordnung mit

    a) einer ersten und zweiten aus jeweils wenigstens zwei Transistoren ($T_1$, $T_2$; $T_3$, $T_4$) unsymmetrisch aufgebauten Differenzverstärkerstufe, deren jeweiligen beiden Eingängen ($E_1$, $E_2$; $E_3$, $E_4$) hinsichtlich der Unsymmetrie ungleichsinnig zu einem ersten und zweiten Eingang ($E_1/E_4$, $E_2/E_3$) der Schaltungsanordnung verbunden sind, wobei

    b) die Unsymmetrie der beiden Differenzverstärkerstufen jeweils durch ein Flächen- oder Breitenverhältnis der zugehörigen Transistoren ($T_1$, $T_2$; $T_3$, $T_4$) erzeugt wird,

    c) die beiden Differenzverstärkerstufen von im wesentlichen konstanten, untereinander identischen Strömen ($I_1$, $I_2$) versorgt werden,

    d) die Ausgänge ($A_{C1}$, $A_{C2}$; $A_{C3}$, $A_{C4}$) der beiden Differenzverstärkerstufen hinsichtlich der Unsymmetrie gleichsinnig verbunden und an eine Ausgangsschaltung (6a, 6b) angeschlossen werden,

    e) dem ersten und zweiten Eingang ($E_1/E_4$, $E_2/E_3$) der Schaltungsanordnung das Wechselspannungssignal ($U_e$) zugeführt wird, dadurch gekennzeichnet, daß

    f) an den verbundenen Ausgängen ($A_{C1}/A_{C3}$, $A_{C2}/A_{C4}$) der beiden Differenzverstärkerstufen das gleichgerichtete Wechselspannungssignal ($U_A$) abgegriffen wird, und

g) die Ausgangsschaltung (6a) zwei ohmsche Arbeitswiderstände (R1, R2) enthält, die jeweils an einem Ausgang ($A_1$, $A_2$) geschaltet sind und deren Leitwerte im Verhältnis der Unsymmetrie gemäß Merkmal b) ausgebildet sind.

2. Verfahren zur Gleichrichtung eines von einer Signalquelle (4) erzeugten Wechselspannungssignals ($U_e$) unter Verwendung einer Schaltungsanordnung mit

a) einer ersten und zweiten aus jeweils wenigstens zwei Transistoren ($T_1$, $T_2$; $T_3$, $T_4$) unsymmetrisch aufgebauten Differenzverstärkerstufe, deren jeweilige beide Eingänge ($E_1$, $E_2$; $E_3$, $E_4$) hinsichtlich der Unsymmetrie ungleichsinnig zu einem ersten und zweiten Eingang ($E_1$/$E_4$, $E_2$/$E_3$) der Schaltungsanordnung verbunden sind, wobei

b) die Unsymmetrie der beiden Differenzverstärkerstufen jeweils durch ein Flächen- oder Breitenverhältnis der zugehörigen Transistoren ($T_1$, $T_2$; $T_3$, $T_4$) erzeugt wird,

c) die beiden Differenzverstärkerstufen von im wesentlichen konstanten, untereinander identischen Strömen ($I_1$, $I_2$) versorgt werden,

d) die Ausgänge ($A_{C1}$, $A_{C2}$; $A_{C3}$, $A_{C4}$) der beiden Differenzverstärkerstufen hinsichtlich der Unsymmetrie gleichsinnig verbunden und an eine Ausgangsschaltung (6a, 6b) angeschlossen werden,

e) dem ersten und zweiten Eingang ($E_1$/$E_4$, $E_2$/$E_3$) der Schaltungsanordnung das Wechselspannungssignal ($U_e$) zugeführt wird, dadurch gekennzeichnet, daß

f) an den verbundenen Ausgängen ($A_{C1}$/$A_{C3}$, $A_{C2}$/$A_{C4}$) der beiden Differenzverstärkerstufen das gleichgerichtete Wechselspannungssignal ($U_A$) abgegriffen wird, und

g) die Ausgangsschaltung (6b) eine Stromspiegelschaltung ($T_7$, $T_8$) enthält, die beide Ausgänge ($A_1$, $A_2$) über diese Stromspiegelschaltung ($T_7$, $T_8$) Verbindet und die Stromspiegelschaltung ($T_7$, $T_8$) einen Spiegelfaktor entsprechend der Unsymmetrie gemäß Merkmal b) aufweist.

3. Verfahren zur Gleichrichtung eines von einer Signalquelle (4) erzeugten Wechselspannungssignals ($U_e$) unter Verwendung einer Schaltungsanordnung mit

a) einer ersten und zweiten aus jeweils wenigstens zwei Transistoren ($T_1$, $T_2$; $T_3$, $T_4$) symmetrisch aufgebauten Differenzverstärkerstufe, deren Eingänge ($E_1$, $E_2$; $E_3$, $E_4$) derart verbunden sind, daß die beiden Eingänge ($E_2$, $E_4$) der ersten Differenzverstärkerstufe einen ersten und zweiten Eingang ($E_2$, $E_4$) der Schaltungsanordnung bilden und

b) zur Erzeugung einer funktionellen Unsymmetrie die beiden Eingänge ($E_3$, $E_1$) der zweiten Differenzverstärkerstufe jeweils über eine Eingangs-Offsetspannung ($R_5$, $R_3$) mit dem ersten und zweiten Eingang ($E_2$, $E_4$) der Schaltungsanordnung verbunden sind, wobei die Eingangs-Offset-Spannung beider Differenzverstärkerstufen jeweils durch eine dem Wechselspannungssignal ($U_e$) zu überlagernde Hilfsspannung ($U_{H1}$, $U_{H2}$) erzeugt wird,

c) die beiden Differenzverstärkerstufen von im wesentlichen konstanten, untereinander identischen Strömen ($I_1$, $I_2$) versorgt werden,

d) die Ausgänge ($A_{C1}$, $A_{C2}$; $A_{C3}$, $A_{C4}$) der beiden Differenzverstärkerstufen hinsichtlich der Unsymmetrie gleichsinnig verbunden und an eine Ausgangsschaltung (6a, 6b) angeschlossen werden,

e) dem ersten und zweiten Eingang ($E_2$, $E_4$) der Schaltungsanordnung das Wechselspannungssignal ($U_e$) zugeführt wird, dadurch gekennzeichnet, daß

f) an den verbundenen Ausgängen ($A_{C1}$/$A_{C3}$; $A_{C2}$/$A_{C4}$) der beiden Differenzverstärkerstufen das gleichgerichtete Wechselspannungssignal ($U_A$) abgegriffen wird, und

g) die Ausgangsschaltung (6a) zwei ohmsche Arbeitswiderstände (R1, R2) enthält, die jeweils an einen Ausgang ($A_1$, $A_2$) geschaltet sind und deren Leitwerte im Verhältnis der Unsymmetrie der Diffferenzverstärkerstufen gemäß Merkmal b) ausgebildet sind.

4. Verfahren zur Gleichrichtung eines von einer Signalquelle (4) erzeugten Wechselspannungssignals ($U_e$) unter Verwendung einer Schaltungsanordnung mit

a) einer ersten und zweiten aus jeweils wenigstens zwei Transistoren ($T_1$, $T_2$; $T_3$, $T_4$) symme-

trisch aufgebauten Differenzverstärkerstufe, deren Eingänge ($E_1$, $E_2$; $E_3$, $E_4$) derart verbunden sind, daß die beiden Eingänge ($E_2$, $E_4$) der ersten Differenzverstärkerstufe einen ersten und zweiten Eingang ($E_2$, $E_4$) der Schaltungsanordnung bilden und

b) zur Erzeugung einer funktionellen Unsymmetrie die beiden Eingänge ($E_3$, $E_1$) der zweiten Differenzverstärkerstufe jeweils über eine Eingangs-Offsetspannung ($R_5$, $R_3$) mit dem ersten und zweiten Eingang ($E_2$, $E_4$) der Schaltungsanordnung verbunden sind, wobei die Eingangs-Offset-Spannung beider Differenzverstärkerstufen jeweils durch eine dem Wechselspannungssignal ($U_e$) zu überlagernde Hilfsspannung ($U_{H1}$, $U_{H2}$) erzeugt wird,

c) die beiden Differenzverstärkerstufen von im wesentlichen konstanten, untereinander identischen Strömen ($I_1$, $I_2$) versorgt werden,

d) die Ausgänge ($A_{C1}$, $A_{C2}$; $A_{C3}$, $A_{C4}$) der beiden Differenzverstärkerstufen hinsichtlich der Unsymmetrie gleichsinnig verbunden und an eine Ausgangsschaltung (6a, 6b) angeschlossen werden,

e) dem ersten und zweiten Eingang ($E_2$, $E_4$) der Schaltungsanordnung das Wechseispannungssignal ($U_e$) zugeführt wird, dadurch gekennzeichnet, daß

f) an den verbundenen Ausgängen ($A_{C1}/A_{C3}$; $A_{C2}/A_{C4}$) der beiden Differenzverstärkerstufen das gleichgerichtete Wechselspannungssignal ($U_A$) abgegriffen wird, und

g) die Ausgangsschaltung (6b) eine Stromspiegelschaltung ($T_7$, $T_8$) enthält, die beide Ausgänge ($A_1$, $A_2$) über diese Stromspiegelschaltung ($T_7$, $T_8$) verbindet und die Stromspiegelschaltung ($T_7$, $T_8$) einen Spiegelfaktor entsprechend der Unsymmetrie der Differenzverstärkerstufen gemäß Merkmal b) aufweist.

5. verfahren nach Anspruch 3 oder 4, dadurch gekennzeichnet, daß eine Schaltungsanordnung verwendet wird, bei der eine dritte Differenzverstärkerstufe mit einem fünften und sechsten Transistor ($T_5$, $T_6$) vorgesehen ist, die von der Signalquelle (4) angesteuert wird und daß die Hilfsspannung ($U_{H1}$, $U_{H2}$) mittels Abgriffen an den Arbeitswiderständen ($R_3$, $R_4$; $R_5$, $R_6$) dieser dritten Differenzverstärkerstufe erzeugt werden.

**Claims**

1. A method of rectifying an alternating voltage signal ($U_e$) produced by a signal source (4), using a circuit arrangement comprising

   a) a first and second asymmetrical differential amplifier stage each comprising at least two transistors ($T_1$, $T_2$; $T_3$, $T_4$) whose respective two inputs ($E_1$, $E_2$; $E_3$, $E_4$) are connected to a first and second input ($E_1/E_4$; $E_2/E_3$) of the circuit arrangement in opposite senses in regard to the asymmetry of the arrangement, whereby

   b) the asymmetrical arrangement of the two differential amplifier stages is produced by means of a surface area ratio or a width ratio of the appertaining transistors ($T_1$, $T_2$; $T_3$, $T_4$),

   c) the two differential amplifier stages are fed by substantially constant, mutually identical currents ($I_1$, $I_2$),

   d) the outputs ($A_{C1}$, $A_{C2}$; $A_{C3}$, $A_{C4}$) of the two differential amplifier stages are interconnected in the same sense in regard to the asymmetry of the arrangement, and are connected to an output circuit (6a, 6b),

   e) the alternating voltage signal ($U_e$) is supplied to the first and second input ($E_1/E_4$; $E_2/E_3$) of the circuit arrangement, characterised in that

   f) the rectified alternating voltage signal ($U_A$) is tapped off from the interconnected outputs ($A_{C1}/A_{C3}$; $A_{C2}/A_{C4}$) of the two differential amplifier stages, and

   g) the output circuit (6a) comprises two ohmic load resistors ($R_1$, $R_2$) which are connected to a respective output ($A_1$, $A_2$), and their conductances are formed in proportion to the asymmetry according to feature b).

2. A method of rectifying an alternating voltage signal ($U_e$) produced by a signal source (4), using a circuit arrangement comprising

   a) a first and second asymmetrical differential amplifier stage each comprising at least two transistors ($T_1$, $T_2$; $T_3$, $T_4$) whose respective two inputs ($E_1$, $E_2$; $E_3$, $E_4$) are connected to a first and second input ($E_1/E_4$; $E_2/E_3$) of the circuit arrangement in opposite senses in regard to the asymmetry of the arrangement, whereby

   b) the asymmetrical arrangement of the two differential amplifier stages is produced by means of a surface area ratio or a width ratio of the appertaining transistors ($T_1$, $T_2$; $T_3$, $T_4$),

c) the two differential amplifier stages are fed by substantially constant, mutually identical currents ($I_1$, $I_2$),

d) the outputs ($A_{C1}$, $A_{C2}$; $A_{C3}$, $A_{C4}$) of the two differential amplifier stages are interconnected in the same sense in regard to the asymmetry of the arrangement, and are connected to an output circuit (6a, 6b),

e) the alternating voltage signal ($U_e$) is supplied to the first and second input ($E_1/E_4$; $E_2/E_3$) of the circuit arrangement, characterised in that

f) the rectified alternating voltage signal ($U_A$) is tapped off from the interconnected outputs ($A_{C1}/A_{C3}$; $A_{C2}/A_{C4}$) of the two differential amplifier stages, and

g) the output circuit (6b) comprises a current mirror circuit ($T_7$, $T_8$) which connects the two outputs ($A_1$, $A_2$) via this current mirror circuit ($T_7$, $T_8$), and the current mirror circuit ($T_7$, $T_8$) has a reflection factor corresponding to the asymmetry according to feature b).

3. A method of rectifying an alternating voltage signal ($U_e$) produced by a signal source (4), using a circuit arrangement comprising

a) a first and second asymmetrical differential amplifier stage each comprising at least two transistors ($T_1$, $T_2$; $T_3$, $T_4$) whose inputs ($E_1$, $E_2$; $E_3$, $E_4$) are connected in such a manner that the two inputs ($E_2$, $E_4$) of the first differential amplifier stage form a first and second input ($E_2$, $E_4$) of the circuit arrangement and

b) for the purposes of producing a functionally asymmetrical arrangement, the two inputs ($E_3$, $E_1$) of the second differential amplifier stage are connected via a respective input off-set voltage ($R_5$, $R_3$) to the first and second input ($E_2$, $E_4$) of the circuit arrangement, whereby the input off-set voltage of the two differential amplifier stages is produced by a respective auxiliary voltage ($U_{H1}$, $U_{H2}$) that is to be superimposed on the alternating voltage signal ($U_e$),

c) the two differential amplifier stages are fed by substantially constant, mutually identical currents ($I_1$, $I_2$),

d) the outputs ($A_{C1}$, $A_{C2}$; $A_{C3}$, $A_{C4}$) of the two differential amplifier stages are interconnected in the same sense in regard to the asymmetry of the arrangement, and are connected to an output circuit (6a, 6b),

e) the alternating voltage signal ($U_e$) is supplied to the first and second input ($E_2$; $E_4$) of the circuit arrangement, characterised in that

f) the rectified alternating voltage signal ($U_A$) is tapped off from the interconnected outputs ($A_{C1}/A_{C3}$; $A_{C2}/A_{C4}$) of the two differential amplifier stages, and

g) the output circuit (6a) comprises two ohmic load resistors ($R_1$, $R_2$) which are connected to a respective output ($A_1$, $A_2$), and their conductances are formed in proportion to the asymmetry of the differential amplifier stages according to feature b).

4. A method of rectifying an alternating voltage signal ($U_e$) produced by a signal source (4), using a circuit arrangement comprising

a) a first and second asymmetrical differential amplifier stage each comprising at least two transistors ($T_1$, $T_2$; $T_3$, $T_4$) whose inputs ($E_1$, $E_2$; $E_3$, $E_4$) are connected in such a manner that the two inputs ($E_2$, $E_4$) of the first differential amplifier stage form a first and second input ($E_2$, $E_4$) of the circuit arrangement and

b) for the purposes of producing a functionally asymmetrical arrangement, the two inputs ($E_3$, $E_1$) of the second differential amplifier stage are connected via a respective input off-set voltage ($R_5$, $R_3$) to the first and second input ($E_2$, $E_4$) of the circuit arrangement, whereby the input off-set voltage of the two differential amplifier stages is produced by a respective auxiliary voltage ($U_{H1}$, $U_{H2}$) that is to be superimposed on the alternating voltage signal ($U_e$),

c) the two differential amplifier stages are fed by substantially constant, mutually identical currents ($I_1$, $I_2$),

d) the outputs ($A_{C1}$, $A_{C2}$; $A_{C3}$, $A_{C4}$) of the two differential amplifier stages are interconnected in the same sense in regard to the asymmetry of the arrangement, and are connected to an output circuit (6a, 6b),

e) the alternating voltage signal ($U_e$) is supplied to the first and second input ($E_2$; $E_4$) of the circuit arrangement, characterised in that

f) the rectified alternating voltage signal ($U_A$) is tapped off from the interconnected outputs ($A_{C1}$/$A_{C3}$; $A_{C2}$/$A_{C4}$) of the two differential amplifier stages, and

g) the output circuit (6b) comprises a current mirror circuit ($T_7$, $T_8$) which connects the two outputs ($A_1$, $A_2$) via this current mirror circuit ($T_7$, $T_8$), and the current mirror circuit ($T_7$, $T_8$) has a reflection factor corresponding to the asymmetry of the differential amplifier stages according to feature b).

**5.** A method in accordance with claim 3 or 4, characterised in that a circuit arrangement is used wherein there is provided a third differential amplifier stage incorporating a fifth and a sixth transistor ($T_5$, $T_6$), this stage being controlled by the signal source (4), and in that the auxiliary voltages ($U_{H1}$, $U_{H2}$) are produced by means of tappings on the load resistors ($R_3$, $R_4$; $R_5$, $R_6$) of this third differential amplifier stage.

**Revendications**

**1.** Procédé pour redresser un signal de tension alternative ($U_e$) produit par une source de signaux (4), moyennant l'utilisation d'un montage comportant

a) des premier et second étages amplificateurs différentiels constitués avec un agencement dissymétrique par au moins deux transistors ($T_1$,$T_2$;$T_3$,$T_4$) et dont les deux entrées respectives ($E_1$,$E_2$;$E_3$,$E_4$) sont reliées, en rapport avec la dissymétrie, en des sens opposés à des première et seconde entrées ($E_1$/$E_4$; $E_2$/$E_3$) du montage, selon lequel
b) la dissymétrie des deux étages amplificateurs différentiels est produite respectivement par un rapport de surfaces ou un rapport de largeurs des transistors associés ($T_1$,$T_2$;$T_3$,$T_4$),
c) les deux étages amplificateurs différentiels sont alimentés par des courants essentiellement constants et identiques entre eux ($I_1$,$I_2$),
d) les sorties ($A_{C1}$,$A_{C2}$;$A_{C3}$,$A_{C4}$) des deux étages amplificateurs différentiels sont reliées dans le même sens, en rapport avec la dissymétrie, et sont connectées à un circuit de sortie (6a,6b),
e) le signal de tension alternative ($U_e$) est envoyé aux première et seconde entrées ($E_1$/$E_4$, $E_2$/$E_3$) du montage,
     caractérisé en ce que
f) le signal de tension alternative redressé ($U_A$) est prélevé sur les sorties réunies ($A_{C1}$/$A_{C3}$, $A_{C2}$/$A_{C4}$) des deux étages amplificateurs différentiels, et
g) le circuit de sortie (6a) contient deux résistances ohmiques de travail (R1,R2), qui sont connectées respectivement à une sortie ($A_1$, $A_2$), et leurs valeurs de conductance sont choisies dans le rapport de la dissymétrie conformément à la caractéristique b).

**2.** Procédé pour redresser un signal de tension alternative ($U_e$) produit par une source de signaux (4), moyennant l'utilisation d'un montage comportant

a) des premier et second étages amplificateurs différentiels constitués avec un agencement dissymétrique par au moins deux transistors ($T_1$,$T_2$;$T_3$,$T_4$) et dont les deux entrées respectives ($E_1$,$E_2$;$E_3$,$E_4$) sont reliées, en rapport avec la dissymétrie, en des sens opposés à des première et seconde entrées ($E_1$/$E_4$; $E_2$/$E_3$) du montage, selon lequel
b) la dissymétrie des deux étages amplificateurs différentiels est produite respectivement par un rapport de surfaces ou un rapport de largeurs des transistors associés ($T_1$,$T_2$;$T_3$,$T_4$),
c) les deux étages amplificateurs différentiels sont alimentés par des courants essentiellement constants et identiques entre eux ($I_1$,$I_2$),
d) les sorties ($A_{C1}$,$A_{C2}$;$A_{C3}$,$A_{C4}$) des deux étages amplificateurs différentiels sont reliées dans le même sens, en rapport avec la dissymétrie, et sont connectées à un circuit de sortie (6a,6b),
e) le signal de tension alternative ($U_e$) est envoyé aux première et seconde entrées ($E_1$/$E_4$, $E_2$/$E_3$) du montage,
     caractérisé en ce que
f) le signal de tension alternative redressé ($U_A$) est prélevé sur les sorties réunies ($A_{C1}$/$A_{C3}$, $A_{C2}$/$A_{C4}$) des deux étages amplificateurs différentiels, et
g) le circuit de sortie (6b) contient un circuit formant miroir de courant ($T_7$,$T_8$), qui relie les deux sorties ($A_1$,$A_2$) au moyen de ce circuit formant miroir de courant ($T_7$,$T_8$) et le circuit formant miroir de courant ($T_7$,$T_8$) possède un facteur de réflexion correspondant à la dissymétrie conformément à la caractéristique b).

**3.** Procédé pour redresser un signal de tension alternative ($U_e$) produit par une source de signaux (4), moyennant l'utilisation d'un montage comportant

a) des premier et second étages amplificateurs différentiels constitués selon un agencement symétrique par respectivement au moins deux transistors ($T_1$,$T_2$;$T_3$,$T_4$), dont les entrées ($E_1$, $E_2$;$E_3$,$E_4$) sont reliées de telle sorte que les deux entrées ($E_2$,$E_4$) du premier amplificateur différentiel forment des première et seconde entrées ($E_2$,$E_4$) du montage, et

b) pour la production d'une dissymétrie fonctionnelle, les deux entrées ($E_3$,$E_1$) du second étage amplificateur différentiel sont reliées respectivement par l'intermédiaire d'une tension d'offset d'entrée ($R_5$,$R_3$) aux première et seconde entrées ($E_2$,$E_4$) du montage, la tension d'offset d'entrée des deux étages amplificateurs différentiels étant produite respectivement par une tension auxiliaire ($U_{H1}$,$H_{H2}$) qui doit être superposée au signal de tension alternative ($U_e$),

c) les deux étages amplificateurs différentiels sont alimentés par des courants essentiellement constants et identiques entre eux ($I_1$,$I_2$),

d) les sorties ($A_{C1}$,$A_{C2}$;$A_{C3}$,$A_{C4}$) des deux étages amplificateurs différentiels sont reliées dans le même sens, en rapport avec la dissymétrie, et sont connectées à un circuit de sortie (6a,6b),

e) le signal de tension alternative ($U_e$) est envoyé aux première et seconde entrées ($E_2$/$E_4$) du montage,

caractérisé en ce que

f) le signal de tension alternative redressé ($U_A$) est prélevé sur les sorties réunies ($A_{C1}$/$A_{C3}$; $A_{C2}$/$A_{C4}$) des deux étages amplificateurs différentiels, et

g) le circuit de sortie (6a) contient deux résistances ohmiques de travail (R1,R2), qui sont connectées respectivement à une sortie ($A_1$, $A_2$), leurs valeurs de conductance étant choisies dans le rapport de la dissymétrie des étages amplificateurs différentiels conformément à la caractéristique b).

4. Procédé pour redresser un signal de tension alternative ($U_e$) produit par une source de signaux (4), moyennant l'utilisation d'un montage comportant

a) des premier et second étages amplificateurs différentiels constitués selon un agencement symétrique par respectivement au moins deux transistors ($T_1$,$T_2$;$T_3$,$T_4$), dont les entrées ($E_1$, $E_2$;$E_3$,$E_4$) sont reliées de telle sorte que les deux entrées ($E_2$,$E_4$) du premier amplificateur différentiel forment des première et seconde entrées ($E_2$,$E_4$) du montage, et

b) pour la production d'une dissymétrie fonctionnelle, les deux entrées ($E_3$,$E_1$) du second étage amplificateur différentiel sont reliées respectivement par l'intermédiaire d'une tension d'offset d'entrée ($R_5$,$R_3$) aux première et seconde entrées ($E_2$,$E_4$) du montage, la tension d'offset d'entrée des deux étages amplificateurs différentiels étant produite respectivement par une tension auxiliaire ($U_{H1}$,$H_{H2}$) qui doit être superposée au signal de tension alternative ($U_e$),

c) les deux étages amplificateurs différentiels sont alimentés par des courants essentiellement constants et identiques entre eux ($I_1$,$I_2$),

d) les sorties ($A_{C1}$,$A_{C2}$;$A_{C3}$,$A_{C4}$) des deux étages amplificateurs différentiels sont reliées dans le même sens, en rapport avec la dissymétrie, et sont connectées à un circuit de sortie (6a,6b),

e) le signal de tension alternative ($U_e$) est envoyé aux première et seconde entrées ($E_2$/$E_4$) du montage,

caractérisé en ce que

f) le signal de tension alternative redressé ($U_A$) est prélevé sur les sorties réunies ($A_{C1}$/$A_{C3}$; $A_{C2}$/$A_{C4}$) des deux étages amplificateurs différentiels, et

g) le circuit de sortie (6b) contient un circuit formant miroir de courant ($T_7$,$T_8$), qui relie les deux sorties ($A_1$,$A_2$) par l'intermédiaire de ce circuit formant miroir de courant ($T_7$,$T_8$) et le circuit formant miroir de courant ($T_7$,$T_8$) possède un facteur de symétrie correspondant à la dissymétrie des étages amplificateurs différentiels conformément à la caractéristique b).

5. Procédé selon la revendication 3 ou 4, caractérisé en ce qu'on utilise un montage, dans lequel il est prévu un troisième étage amplificateur différentiel, qui comporte des cinquième et sixième transistors ($T_5$,$T_6$) et qui est commandé par la source de signaux (4) et que la tension auxiliaire ($U_{H1}$,$U_{H2}$) est produite au moyen de prises au niveau des résistances de travail ($R_3$,$R_4$;$R_5$,$R_6$) de ce troisième étage amplificateur différentiel.

FIG.1

FIG.2

FIG.3

FIG.4

FIG.5

FIG.6